# EUROPEAN PATENT APPLICATION

(11) **EP 2 053 665 A2**
(43) Date of publication of application: **29.04.2009**
(21) Application number: 08167335.2
(22) Date of filing: 22.10.2008
(51) Int. Cl.: H01L 31/18, H01L 21/66

(54) **Process testers and testing methodology for thin-film photovoltaic devices**

(30) Priority: 22.10.2007 US 876346
(71) Applicant: Applied Materials, Inc., Santa Clara, CA 95054 (US)
(72) Inventor: Frei, Michel Ranjit, Palo Alto, CA 94306 (US); Su, Tzay-Fa, San Jose, CA 95125 (US)
(74) Representative: Zimmermann & Partner

(57) **Abstract**

The present invention generally relates to process testers and methods of fabricating the same using standard photovoltaic cell processes. In particular, the present invention relates to process tester layouts defined by laser scribing, methodology for creating process testers, methodology of using process testers for photovoltaic line diagnostics, placement of process testers in photovoltaic module production, and methodology for creating design rule testers.

## Description

Embodiments of the present invention generally relate to photovoltaic devices and fabrication processes thereof. In particular, embodiments of the present invention relate to process testers, methods of manufacturing process testers, and testing methodology for thin-film photovoltaic devices.

Photovoltaic (PV) devices are devices that convert sunlight into direct current (DC) electrical power. A PV device may be classified as monocrystalline, polycrystalline, or thin-film depending on how the device is fabricated.

Monocrystalline PV devices are produced by slicing wafers from a single crystal, high purity, silicon boule. Polycrystalline PV devices are produced by sawing a cast block of silicon into bars, then wafers. Thin-film PV devices are produced by depositing thin layers of materials, such as amorphous silicon, microcrystalline silicon or copper indium gallium selenide (CIGS), onto a suitable substrate.

Although monocrystalline and polycrystalline silicon have traditionally produced PV devices with higher efficiencies, the high cost of crystalline silicon wafers has led the industry into increased use and development of thin-film PV devices.

Accordingly, as the production of thin-film PV devices matures, the need for increased process control has developed. This need is driven by both yield and uniformity considerations. Additionally, fast and effective solving of ramp-up problems associated with new or duplicated production lines is needed as well.

Therefore, a need exists for process testers and testing methodology for thin-film PV devices that can provide, through electrical testing, information directly related to the production process.

In light of the above, a method for forming a device for testing thin-film, photovoltaic production processes according to independent claims 1 and 5, a method for producing devices for testing thin-film, photovoltaic production processes according to independent claims 11 and 12, a method for determining thin-film, photovoltaic cell, tester or module process design rules according to independent claim 13, and a device for testing thin-film, photovoltaic production processes according to independent claims 6 and 10 are provided.

The present invention generally provides process tester layouts defined by laser scribing, methodology for creating process testers, methodology of using process testers for solar line diagnostics, placement of process testers in PV module production, and methodology for creating design rule testers.

In one embodiment of the present invention, a method for forming a device for testing thin-film, photovoltaic production processes comprises forming a front transparent conductive oxide layer over a substrate, laser scribing a groove in the front transparent conductive oxide layer in an isolation region of the device, forming an absorber layer over the front transparent conductive oxide layer, laser scribing a groove in the absorber layer in a first probe region of the device, laser scribing a groove in the absorber layer in a second probe region of the device, forming a back reflective layer over the absorber layer, laser scribing a groove in the back reflective layer in the isolation region of the device, and laser scribing a groove in the back reflective layer in a linking region of the device. In one embodiment, the isolation region electrically isolates the device from adjacent photovoltaic structures.

In another embodiment, a method for forming a device for testing thin-film, photovoltaic production processes comprises forming a front transparent conductive oxide layer over a substrate, laser scribing a groove in the front transparent conductive oxide layer in an isolation region of the device, laser scribing a groove in the transparent conductive oxide layer across an outer and inner active region of the device, forming an absorber layer over the front transparent conductive oxide layer, laser scribing a groove in the absorber layer in the outer active region of the device prior, forming a back reflective layer over the absorber layer, laser scribing a groove in the back reflective layer in the isolation region of the device, and laser scribing a groove in the back reflective layer between the outer active region and the inner active region of the device. In one embodiment, the isolation region electrically isolates the device from adjacent photovoltaic structures.

In another embodiment, a device for testing thin-film, photovoltaic production processes comprises a front transparent conductive oxide layer formed over a substrate, an absorber layer formed over the front transparent conductive oxide layer, and a back reflective layer formed over the absorber layer. In one embodiment, the transparent conductive oxide layer has a groove in an isolation region of the device. In one embodiment, the absorber layer has a groove in a first probe region of the device and a groove in a second probe region of the device. In one embodiment, the back reflective layer has a groove in the isolation region of the device. In one embodiment, the isolation region electrically isolates the device from adjacent photovoltaic structures. In one embodiment, wherein the back reflective layer has a groove in a linking region of the device.

In another embodiment, a device for testing thin-film, photovoltaic production processes comprises a front transparent conductive oxide layer formed over a substrate, an absorber layer formed over the front transparent conductive oxide layer, and a back reflective layer formed over the absorber layer, wherein. In one embodiment, the transparent conductive oxide layer has a groove in an isolation region of the device and a groove across an outer and inner active region of the device. In one embodiment, the absorber layer has a groove in the outer active region of the device. In one embodiment, the back reflective layer has a groove in the isolation region of the device, the isolation region electrically isolates the device from adjacent photovoltaic structures, and the back reflective layer has a groove between the outer active region and the inner active region of the device.

In another embodiment, a method for producing devices for testing thin-film, photovoltaic production processes comprises forming a plurality of devices on a single substrate, wherein the devices are defined via laser scribing, wherein the plurality of devices is selected from the group consisting of a tester for measuring the contact resistance between a front transparent conductive oxide layer and a back reflective layer, a tester for measuring the back reflective layer sheet resistance, a tester for measuring the front transparent conductive oxide layer sheet resistance, and a tester for measuring diode characteristics, and wherein the location, position, and number of devices are manipulated and controlled during the production of photovoltaic modules.

In another embodiment, a method for producing devices for testing thin-film, photovoltaic production processes comprises forming a photovoltaic module on a substrate and forming a photovoltaic process tester on the substrate, wherein the tester is defined via laser scribing, wherein the tester is selected from the group consisting of a tester for measuring the contact resistance between a front transparent conductive oxide layer and a back reflective layer, a tester for measuring the back reflective layer sheet resistance, a tester for measuring the front transparent conductive oxide layer sheet resistance, and a tester for measuring diode characteristics, and wherein the tester is located in a cut area of the substrate.

In yet another embodiment of the present invention, a method for determining thin-film, photovoltaic cell, tester or module process design rules comprises forming a plurality of photovoltaic cells and laser scribing grooves in each layer of the cells, wherein lateral distances between the grooves are varied to determine spacing for desired process characteristics. In one embodiment, the photovoltaic cells comprise a transparent conductive oxide layer formed over a substrate, an absorber layer formed over the transparent conductive oxide layer, and a back reflective layer formed over the absorber layer.

Further advantages, features, aspects and details that can be combined with embodiments described herein are evident from the dependent claims, the description and the drawings.

The invention is also directed to a device for carrying out the disclosed methods and including device parts for performing each described method steps. Furthermore, the invention is also directed to methods by which the described device operates. It includes method steps for carrying out every function of the device.

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figure 1 is a schematic cross-section of a thin-film PV module showing series connections between individual cells.

Figure 2 is a schematic cross-sectional view of an embodiment of a tester for measuring the contact resistance between a TCO layer and a back reflective layer.

Figure 3 is a schematic cross-sectional view of an embodiment of a tester for measuring the sheet resistance in a back reflective layer.

Figure 4 is a schematic cross-sectional view of an embodiment of a tester for measuring sheet resistance of a front TCO layer.

Figure 5A is a schematic top view of a tester for performing diode measurements.

Figure 5B is a schematic cross-sectional view of the tester in Figure 5A along line 5-5.

Figure 6 is a schematic top view of an exemplary embodiment of groups of testers produced on a single substrate.

Figure 7 is a schematic top view of four solar modules formed atop a single substrate.

Figure 8 is a schematic cross-sectional view of an embodiment of the present invention comprising a test module having a series of cells with varied lateral spacing between insulating transparent conductive oxide layer grooves and absorber layer grooves.

The present invention generally comprises process testers fabricated using standard PV device processes or standard photovoltaic cell processes. In particular, the present invention comprises process tester layouts defined by laser scribing, methodology for creating process testers, methodology of using process testers for solar line diagnostics, photovoltaic line diagnostics, placement of process testers in PV module production, and methodology for creating design rule testers.

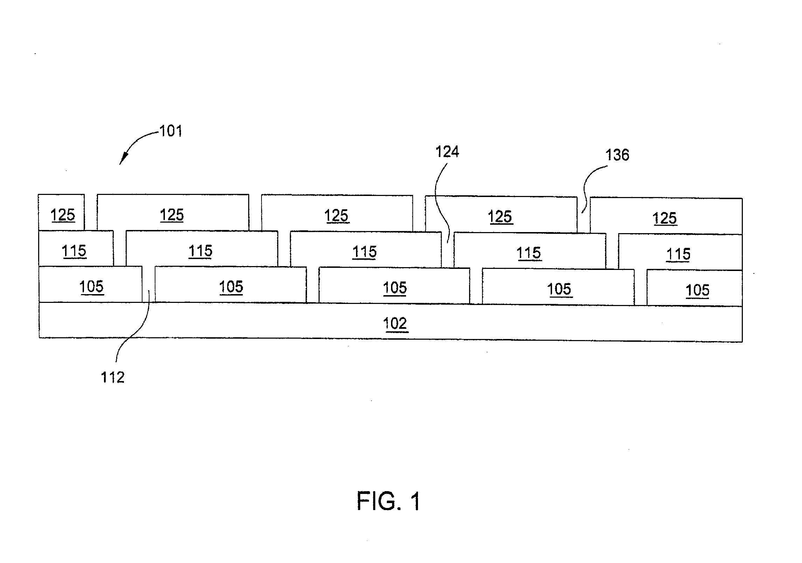

In thin-film PV module fabrication, individual PV cells may be formed and interconnected into a module via laser scribing the layers of the cell. Figure 1 is a schematic cross-section of a thin-film PV module 100 showing series connections between individual cells 101. PV module 100 comprises a substrate 102, such as a glass or polymer substrate, with thin films formed thereover.

In the PV module 100 fabrication process, a front transparent conducting oxide (TCO) layer 105 may be formed over the substrate 102. The TCO layer 105 may comprise tin oxide, zinc oxide, indium tin oxide, cadmium stannate, combinations thereof, or other suitable materials. In a first laser scribing step, a first insulating groove 112 may be created in the TCO layer 105 to interrupt lateral current flow. An absorber layer 115 may then be formed over the TCO layer 105. The absorber layer 115 may comprise layers of thin films, including but not limited to, amorphous silicon, microcrystalline silicon, copper indium gallium selenide (CIGS), or combinations thereof. Next, a second laser scribing may create a groove 124 in the absorber layer 115, which may be filled during the subsequent step of forming a back reflective layer 125 over the absorber layer 115. This results in an interconnection between the front TCO layer 105 and the back reflective layer 125. The back reflective layer 125 may comprise a conductive layer and/or a reflective coating. The conductive layer may be a second TCO layer. The reflective coating may comprise metallic materials including, but not limited to Al, Ag, Ti, Cr, Au, Cu, Pt, alloys thereof, combinations thereof as well as other conductive and reflective materials. Finally, a second insulating groove 136 may be formed in the back reflective layer 125 to interrupt lateral current flow in the back reflective layer 125.

As a result, each individual PV cell 101 of module 100 is electrically connected in series with each adjacent cell 101. Figure 1 depicts five PV cells 101 connected in series via the aforementioned laser scribing process; however, any number of PV cells 101 may be linked in this manner to form PV module 100.

In thin-film PV fabrication, such devices are manufactured on production lines on a large scale. End of line testing may provide finished product information, such as module electrical characteristics, but it does not provide direct information as to the root causes of process failures. Embodiments of the present invention provide testers that may be produced before, during, or after process runs to provide direct information, such as sheet and contact resistance of the conducting layers and the saturation current density of the diode component of the device, needed to diagnose root causes of process failures.

Embodiments of the present invention involve creating process testers by means of the same laser scribing processes used for creating and interconnecting PV cells 101 within PV module 100.

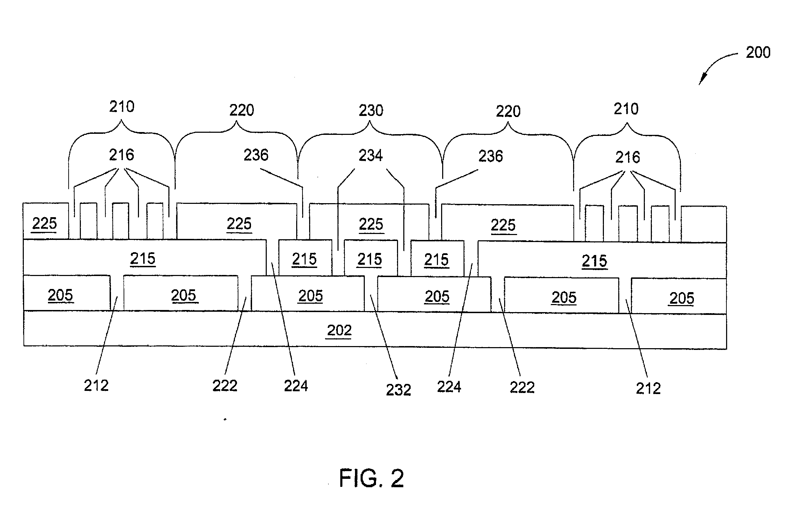

Figure 2 is a schematic cross-sectional view of an embodiment of a tester 200 for measuring the contact resistance between a TCO layer and a back reflective layer. The tester 200 comprises a substrate 202 with thin films formed thereover and divided into isolation regions 210, probe regions 220, and one or more linking regions 230.

In fabricating the tester 200, a front TCO layer 205 may be formed over the substrate 202. In a first laser scribing, TCO insulating grooves 212, 222, and 232 may be created in the TCO layer 205, such that one or more grooves 212 are configured within each isolation region 210, one or more grooves 222 are configured within each probe region 220, and one or more grooves 232 are configured within each linking region 230. Thus, the lateral current in TCO layer 205 is interrupted by insulating grooves 212, 222, and 232.

Next, an absorber layer 215 may be formed over the TCO layer 205. In a second laser scribing, grooves 224 and 234 may be created in absorber layer 215, such that one or more grooves 224 are configured within each probe region 220 and one or more grooves 234 are configured within each linking region 230. Although one or more grooves may be created in each isolation region 210 of the absorber layer 215, this is generally not necessary due to the low lateral conductivity of the absorber layer 215.

Subsequently, a back reflective layer 225 may be formed over the absorber layer 215, such that electrical interconnection is established between the back reflective layer 225 and the TCO layer 205 at grooves 224 and 234. In a final laser scribing, back reflective layer insulating grooves 216 and 236 may be created in the back reflective layer 225, such that one or more grooves 216 are configured within each isolation region 210 and one or more grooves 236 are configured within each linking region 230. Thus, lateral current in back reflective layer 225 is interrupted by insulating grooves 216 and 236.

As shown in Figure 2, the resulting tester 200 comprises isolation regions 210, probe regions 220, and one or more linking regions 230. The isolation regions 210 electrically isolate the tester 200 from adjacent structures. An electrically interconnected chain is established between the probe regions 220 through the one or more linking regions 230, wherein conduction alternates between the back reflective layer 225 and the TCO layer 205. Although Figure 2 depicts one linking region 230, any number of linking regions 230 may be interconnected in the tester 200.

In using the tester 200 for testing the contact resistance between the back reflective layer 225 and the TCO layer 205, electrical probes, such as commonly used in automated testing facilities, may be placed in contact with the back reflective layer 225, within each probe region 220 of the tester 200. The resistance measured between the two probes is dominated by the contact between the back reflective layer 225 and the TCO layer 205. Therefore, the contact resistance is approximately equal to the measured resistance divided by the sum of the number of grooves 224 and 234.

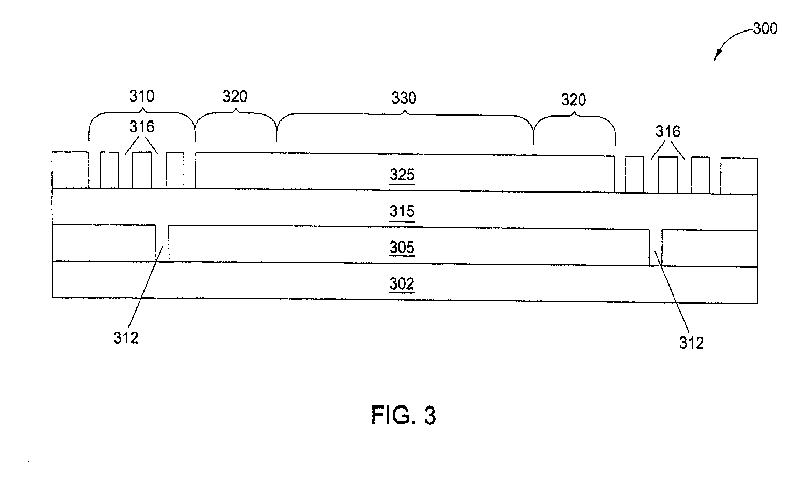

Figure 3 is a schematic cross-sectional view of an embodiment of a tester 300 for measuring the sheet resistance in a back reflective layer. The tester 300 comprises a substrate 302 having thin films formed thereover and divided into isolation regions 310, probe regions 320, and a linking region 330.

In fabricating the tester 300, a front TCO layer 305 may be formed over the substrate 302. In a first laser scribing, a TCO insulating groove 312 may be created in the TCO layer 305, such that one or more grooves 312 are configured within each isolation region 310. Thus, the current in the TCO layer 305 is interrupted by grooves 312.

Next, an absorber layer 315 may be formed over the TCO layer 305. Subsequently, a back reflective layer 325 may be formed over the absorber layer 315.

In a second laser scribing process, one or more insulating grooves 316 may be created within each isolation region 310 to electrically isolate the back metal resistance tester 300 from adjacent structures.

In operation, an electrical probe may be placed in contact with the back reflective layer 325 in each probe region 320, and the resistance between the probes may be measured. Since no electrical interconnection exists between the back reflective layer 325 and the TCO layer 305, the resistance measured between the probes is approximately equivalent to the sheet resistance in the back reflective layer 325.

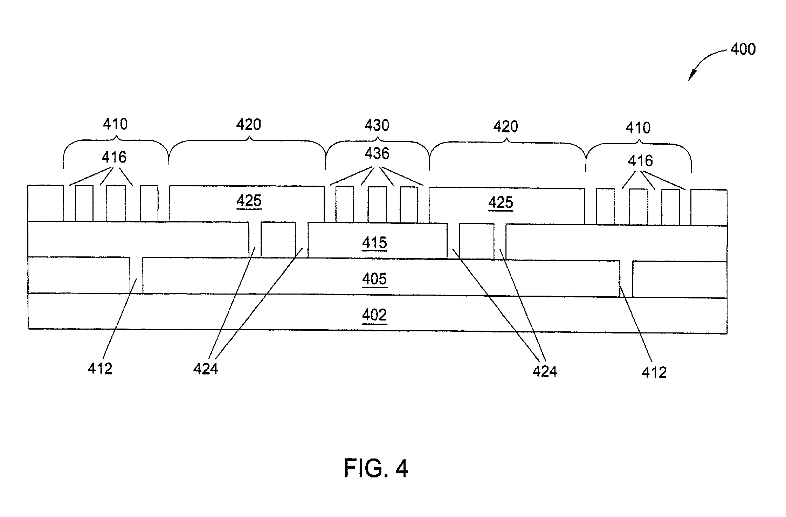

Figure 4 is a schematic cross-sectional view of an embodiment of a tester 400 for measuring sheet resistance of a front TCO layer. Tester 400 comprises a substrate 402 with thin films formed thereover and divided into isolation regions 410, probe regions 420, and a linking region 430.

In fabricating a tester 400, a front TCO layer 405 may be formed over the substrate 402. In a first laser scribing, a TCO insulating groove 412 may be created in the TCO layer 405, such that one or more grooves 412 are configured within each isolation region 410. Thus, the current in the TCO layer 405 is interrupted by grooves 412.

An absorber layer 415 may then be formed over the TCO layer 405. In a second laser scribing process, one or more grooves 424 may be created in absorber layer 415 and configured within each probe region 420.

Subsequently, a back reflective layer 425 may be formed over absorber layer 415, such that an electrical connection is formed between back reflective layer 425 and TCO layer 405 at grooves 424.

In a third laser scribing process, one or more insulating grooves 416 may be created within each isolation region 410 to electrically isolate the tester 400 from adjacent structures. Additionally, one or more insulating grooves 436 may be created within the linking region 430 of tester 400 to interrupt lateral current in the back reflective layer 425.

In operation, an electrical probe may be placed in contact with the back reflective layer 425 in each probe region 420, and the resistance between the probes may be measured. Since the lateral current in the back reflective layer 425 is interrupted via one or more insulating grooves 436, the lateral conduction is dominated by the TCO layer 405. Therefore, the resistance measured between the probes is approximately equivalent to the sheet resistance of the TCO layer 405.

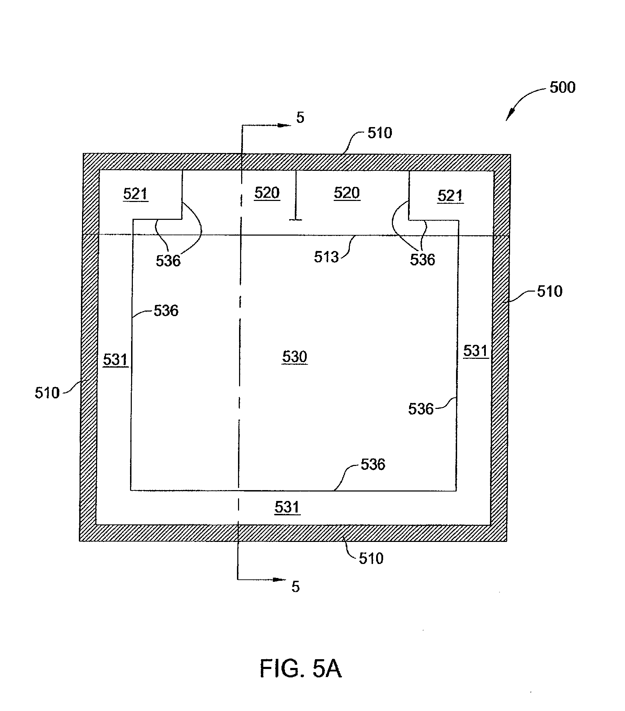

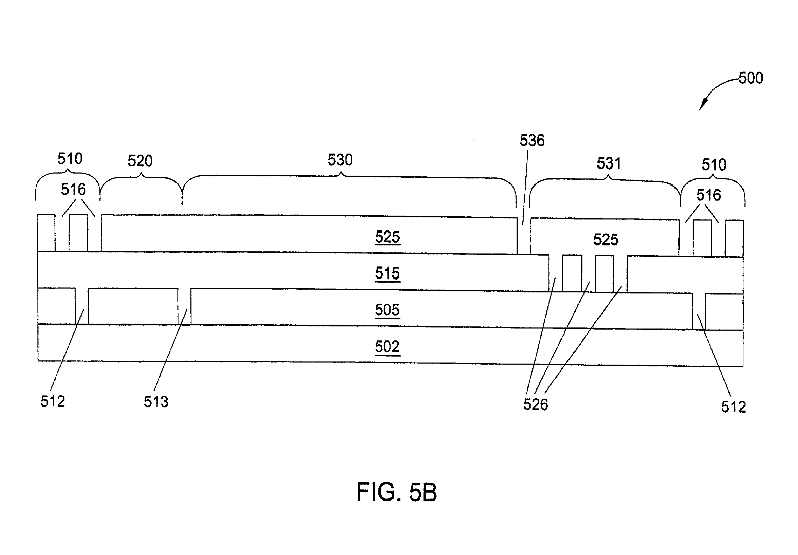

Figure 5A is a schematic top view of a tester 500 for performing diode measurements, and Figure 5B is a schematic cross-sectional view of the tester 500 along line 5-5 of Figure 5A. Tester 500 may comprise a substrate 502 with thin films formed thereover and separated into isolation regions 510, inner probe regions 520, outer probe regions 521, inner active region 530, and outer active region 531.

In fabricating the tester 500, a front TCO layer 505 may be formed over the substrate 502. In a first laser scribing, one or more insulating grooves 512 may be created for interrupting lateral current in the TCO layer 505 and configured within each isolation region 510. Additionally, an insulating groove 513 may be created for interrupting lateral current in the TCO layer 505 and configured through the inner active region 530 and the outer active region 531.

Next, an absorber layer 515 may be formed over the TCO layer 505. In a second laser scribing process, one or more grooves 526 are created in layer 515, within the outer active region 531.

Subsequently, a back reflective layer 525 may be formed over the absorber layer 515, such that an electrical connection is formed between the TCO layer 505 and the back reflective layer 525 through one or more grooves 526.

In a third laser scribing process, one or more insulating grooves 516 may be created in the back reflective layer 525 within each isolation region 510 to electrically isolate the tester 500 from adjacent devices. Additionally, one or more insulating grooves 536 may be created in the back reflective layer 525 to electrically interrupt lateral current in the back reflective layer 525 between the inner active region 530 and the outer active region 531. The one or more insulating grooves 536 also interrupt lateral current between the inner probe regions 520 and the outer probe regions 521 as well as interrupting current between the inner active region 530 and the outer probe regions 521.

In one embodiment, tester 500 may have four probing regions for performing four-terminal measurements. Two terminals may connect to the back reflective layer 525 in the outer probe regions 521 to electrically connect to the TCO layer 505 via the one or more grooves 526 in the outer active region 531. The other two terminals may connect to the back reflective layer 525 in the inner probe regions 520, which is laterally, electrically insulated from the back reflective layer 525 outer probe regions 521 and the outer active region 531. As a result of the configuration of tester 500, a number of measurements may be taken, including but not limited to, dark saturation current, ideality factor, and series resistance. Additionally, with the proper light source, solar cell parameters such as short-circuit current, open-circuit voltage, and fill-factor may be determined.

In fabricating testers of the present invention, a plurality of testers may be produced onto a single substrate. The testers may be defined using computer-aided design software, allowing continuous modification as information is required for process development and yield improvement. For example, if a contact resistance problem is suspected in a particular production run of solar cells, a suite of chain testers may be processed between solar cell production runs. Similarly, if a uniformity problem exists, an array of cells may be fabricated and measured to obtain mapping data. Additionally, in fabrication line ramp-up and line diagnostic settings, a standard set of testers may be fabricated in a fabrication line at a remote location. The testers may then be sent back to a central facility or measured on site. The data may then be compared to data obtained from a reference process. Thus, embodiments of the present invention allow continuous, in-line testing of parameters directly related to the process.

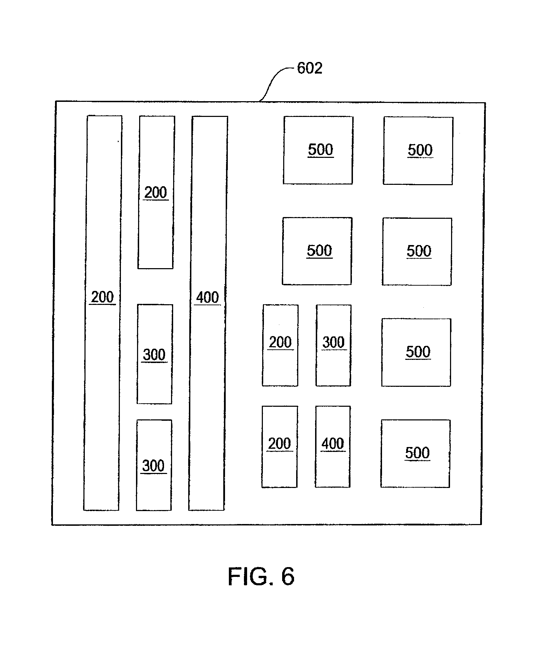

Figure 6 is a schematic top view of an exemplary embodiment of groups of testers 200, 300, 400, and 500 produced on a single substrate 602. In Figure 6, a possible configuration of contact resistance testers 200, metallic layer sheet resistance testers 300, TCO layer sheet resistance testers 400, and diode testers 500 may be grouped and produced on a single substrate 602.

Any number of configurations of groups of testers is possible and is intended within the scope of the invention. For example, a plurality of contact testers 200 may be grouped and produced on a single substrate. Further, testers of the present invention may be grouped and sized for maximum space utilization in any number of combinations.

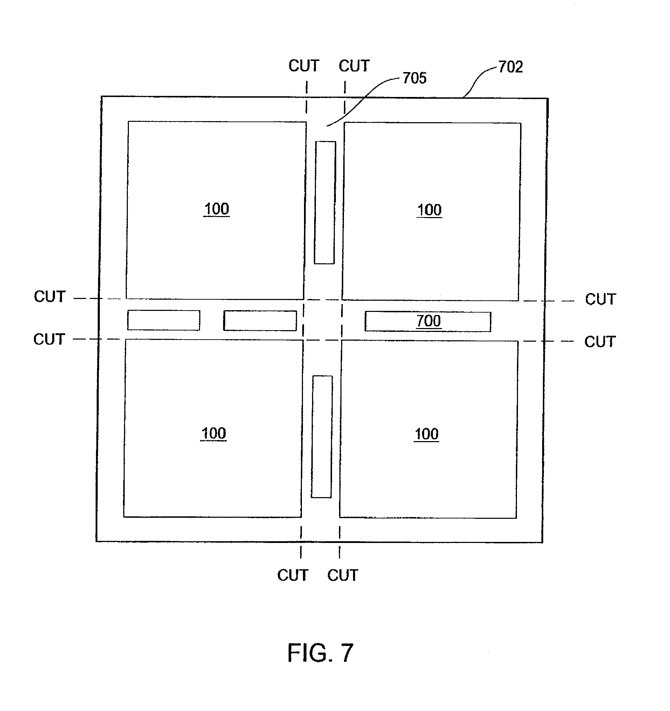

Additionally, process testers according to the present invention may be produced along with solar modules on a single substrate. Figure 7 is a schematic top view of four PV modules 100 formed atop a single substrate 702. During the same production run, testers 700, which may be tester 200, 300, 400, 500, a combination thereof or another tester, may be formed in the cut area 705 between modules 100. After production and testing, the substrate 702 is cut into modules 100, wherein the cut area 705 is destroyed. Figure 7 shows four modules 100 cut from a single substrate; however, any number of modules 100 may be cut from a single substrate. Optionally, testers 700 may be placed in a periphery area, which is also destroyed, or testers 700 may be substituted for one or more of the modules 100. Thus, testers 700 may be formed during normal production runs of PV modules 100 in configurations that make best use of the available space.

Further embodiments of the present invention comprise methods for determining process design rules for producing PV cells, testers or modules for optimum performance, production yield and efficiency.

An embodiment of the present invention comprises methods for determining process design rules associated with spacing of laser scribed grooves in a PV cell, tester or module. For example, to determine the spacing between insulating groove 112 and groove 124 in the PV module of Figure 1, a series of testers with varying spacing may be fabricated. Importantly, the methodology of varying the spacing may be performed automatically via software programming or manually input into the laser scribing system.

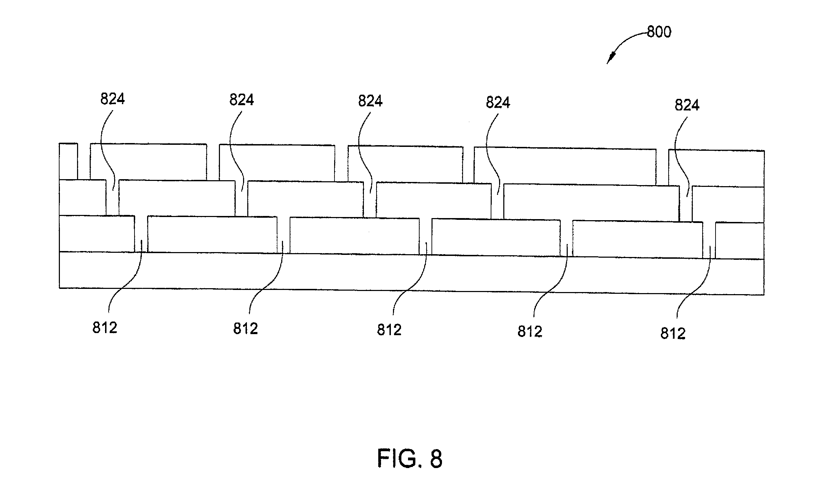

Figure 8 is a schematic cross-sectional view of an embodiment of the present invention 800 comprising a test module having a series of cells with varied spacing between insulating groove 812 and groove 824.

While the foregoing is directed to embodiments of the present invention, other and further embodiments of the invention may be devised without departing from the basic scope thereof, and the scope thereof is determined by the claims that follow.

## Claims

1. A method for forming a device for testing thin-film, photovoltaic production processes, comprising:
forming a front transparent conductive oxide layer (205, 305, 405) over a substrate (202, 302, 402);
laser scribing a groove (212, 312, 412) in the front transparent conductive oxide layer in an isolation region (210, 310, 410) of the device;
forming an absorber layer (215, 315, 415) over the front transparent conductive oxide layer;
laser scribing a groove (224, 424) in the absorber layer in a first probe region (220, 320, 420) of the device;
laser scribing a groove (224, 424) in the absorber layer in a second probe region (220, 320, 420) of the device;
forming a back reflective layer (225, 325, 425) over the absorber layer;
laser scribing a groove (216, 316, 416) in the back reflective layer in the isolation region of the device, wherein the isolation region electrically isolates the device from adjacent photovoltaic structures; and
laser scribing a groove (236, 436) in the back reflective layer in a linking region (230, 430) of the device.

2. The method of claim 1, further comprising laser scribing a groove (222) in the front transparent conductive oxide layer in the first probe region and a groove (222) in the front transparent conductive oxide layer in the second probe region prior to forming the absorber layer.

3. The method of any of the claims 1 to 2, further comprising laser scribing a groove (232) in the front transparent conductive oxide layer in the linking region prior to forming the absorber layer.

4. The method of any of the claims 1 to 3, further comprising laser scribing a groove (234) in the absorber layer in the linking region prior to forming the back reflective layer.

5. A method for forming a device for testing thin-film, photovoltaic production processes, comprising:
forming a front transparent conductive oxide layer (505) over a substrate (502);
laser scribing a groove (512) in the front transparent conductive oxide layer in an isolation region (510) of the device;
laser scribing a groove (513) in the transparent conductive oxide layer across an outer active region (531) and an inner active region (530) of the device;
forming an absorber layer (515) over the front transparent conductive oxide layer;
laser scribing a groove (526) in the absorber layer in the outer active region of the device;
forming a back reflective layer (525) over the absorber layer;
laser scribing a groove (516) in the back reflective layer in the isolation region of the device, wherein the isolation region electrically isolates the device from adjacent photovoltaic structures; and
laser scribing a groove (536) in the back reflective layer between the outer active region and the inner active region of the device.

6. A device for testing thin-film, photovoltaic production processes, comprising:
a front transparent conductive oxide layer (205, 305, 405) formed over a substrate (202, 302, 402), wherein the transparent conductive oxide layer has a groove (212, 312, 412) in an isolation region (210, 310, 410) of the device;
an absorber layer (215, 315, 415) formed over the front transparent conductive oxide layer, wherein the absorber layer has a groove (224, 424) in a first probe region (220, 320, 420) of the device and a groove (224, 424) in a second probe region (220, 320, 420) of the device; and
a back reflective layer (225, 325, 425) formed over the absorber layer, wherein the back reflective layer has a groove (216, 316, 416) in the isolation region of the device, wherein the isolation region electrically isolates the device from adjacent photovoltaic structures, and wherein the back reflective layer has a groove (236, 436) in a linking region (230, 430) of the device.

7. The device of claim 6, wherein the transparent conductive oxide layer has a groove (222) in the first probe region and a groove (222) in the second probe region.

8. The device of any of the claims 6 to 7, wherein the transparent conductive oxide layer has a groove (232) in the linking region.

9. The method of any of the claims 6 to 8, wherein the absorber layer has a groove (234) in the linking region.

10. A device for testing thin-film, photovoltaic production processes, comprising:
a front transparent conductive oxide layer (505) formed over a substrate (502), wherein the transparent conductive oxide layer has a groove (512) in an isolation region (510) of the device, and wherein the front transparent conductive oxide layer has a groove (513) across an outer active region (531) and an inner active region (530) of the device;
an absorber layer (515) formed over the front transparent conductive oxide layer, wherein the absorber layer has a groove (526) in the outer active region of the device; and
a back reflective layer (525) formed over the absorber layer, wherein the back reflective layer has a groove (516) in the isolation region of the device, wherein the isolation region electrically isolates the device from adjacent photovoltaic structures, and wherein the back reflective layer has a groove (536) between the outer active region and the inner active region of the device.

11. A method for producing devices for testing thin-film, photovoltaic production processes, comprising forming a plurality of devices on a single substrate (602), wherein the devices are defined via laser scribing, wherein the plurality of devices is selected from the group consisting of a tester (200) for measuring the contact resistance between a front transparent conductive oxide layer and a back reflective layer, a tester (300) for measuring the back reflective layer sheet resistance, a tester (400) for measuring the front transparent conductive oxide layer sheet resistance, and a tester (500) for measuring diode characteristics, and wherein the location, position, and number of devices are manipulated and controlled during the production of photovoltaic modules.

12. A method for producing devices for testing thin-film, photovoltaic production processes, comprising:
forming a photovoltaic module (100) on a substrate (702); and
forming a photovoltaic process tester (700) on the substrate, wherein the tester is defined via laser scribing, wherein the tester is selected from the group consisting of a tester (200) for measuring the contact resistance between a front transparent conductive oxide layer and a back reflective layer, a tester (300) for measuring the back reflective layer sheet resistance, a tester (400) for measuring the front transparent conductive oxide layer sheet resistance, and a tester (500) for measuring diode characteristics, and wherein the tester is located in a cut area (705) of the substrate.

13. A method for determining thin-film, photovoltaic cell, tester or module process design rules, comprising:
forming a plurality of photovoltaic cells, wherein the photovoltaic cells comprise:
a transparent conductive oxide layer (205, 305, 405, 505) formed over a substrate (202, 302, 402, 502, 602, 702);
an absorber layer (215, 315, 415, 515) formed over the transparent conductive oxide layer; and
a back reflective layer (225, 325, 425, 525) formed over the absorber layer; and
laser scribing grooves (212, 216, 222, 224, 232, 234, 236, 312, 316, 412, 416, 424, 436, 512, 513, 516, 526, 536, 812, 824) in each layer of the cells, wherein lateral distances between the grooves are varied to determine spacing for desired process characteristics.

14. The method of claim 13, wherein lateral distances between the grooves in the transparent conductive oxide layer and grooves in the absorber layer are varied to determine spacing for desired process characteristics.

15. The method of any of the claims 13 to 14, wherein the lateral distances between grooves in the absorber layer and grooves in the back reflective layer are varied to determine spacing for desired process characteristics.
